# FASCICULE DE BREVET EUROPEEN

(11) **EP 0 823 089 B1**
(45) Date de publication et mention de la délivrance du brevet: **08.03.2000**
(21) Numéro de dépôt: 96912093.0
(22) Date de dépôt: 10.04.1996
(51) Int. Cl.: G06F 11/26, G01R 31/28, G06F 11/273

(54) **PROCEDE ET EQUIPEMENT DE TEST AUTOMATIQUE EN PARALLELE DE COMPOSANTS ELECTRONIQUES**
VERFAHREN UND VORRICHTUNG ZUR PARALLELEN AUTOMATISCHEN PRÜFUNG VON ELEKTRONISCHEN SCHALTUNGEN
AUTOMATIC PARALLEL ELECTRONIC COMPONENT TESTING METHOD AND EQUIPMENT

(30) Priorité: 19.04.1995 FR 9504776
(43) Date de publication de la demande: 11.02.1998
(73) Titulaire: SCHLUMBERGER Systèmes, 92120 Montrouge (FR)
(72) Inventeur: FOURNEL, Jean-Claude, F-43140 Saint-Victor Malescours (FR); CHAUSSE, Daniel, F-42100 Saint-Etienne (FR); MURGUE, Jean-Louis, F-42660 Saint-Romain-les-Atheux (FR)
(74) Mandataire: Lemoyne, Didier
(86) Numéro de dépôt international: FR9600541
(87) Numéro de publication internationale: WO9633461

(56) Documents cités:
- EP-A- 0 446 550
- INTERNATIONAL TEST CONFERENCE 1989, 29 Août 1989, WASHINGTON, USA, pages 787-794, XP000090010 KING P.N.: "Flexible, high-performance pin electronics implementation"

## Description

La présente invention concerne un procédé et un équipement de test automatique en parallèle de composants électroniques.

La plupart des composants électroniques numériques commercialisés sont testés par leur fabricant plusieurs fois avant d'être livrés.

Les testeurs de composants ont pour fonction d'une part de générer des signaux numériques, d'état logique 0 ou 1 par exemple, et, d'autre part, de vérifier par comparaison avec une table de test préétablie, la présence de transitions de sortie. Les signaux générés et les signaux comparés sont programmables aussi bien en temps qu'en niveau. D'une manière générale, un testeur de composants doit générer et/ou comparer des signaux simultanément sur toutes les broches fonctionnelles du composant à tester.

La définition des signaux à générer et/ou comparer est le plus souvent extrêmement complexe. Le test d'un microprocesseur peut entraîner des chaînes de plusieurs millions de 0 ou de 1 dans une même séquence. Pour définir ces signaux, on utilise la notion de période qui détermine une bande de temps à l'intérieur de laquelle un signal plus simple est décrit. Ce signal se décompose en une information de temps, appelé aussi marqueur de temps, et en un événement, une transition par exemple.

L'exécution d'un test fonctionnel se traduit ainsi par le déroulement d'une mémoire de programmation de test dont chaque ligne correspond à une période et dont le contenu représente l'information des temps et événements définissant le signal à l'intérieur de la période pour chaque broche. Aux informations de temps et d'événements s'ajoute, entre autres, une instruction destinée à gérer le déroulement de la mémoire de programmation de test. Cette instruction est commune pour l'ensemble des broches fonctionnelles du circuit sous-test. L'instruction la plus courante est celle qui consiste à aller lire la ligne suivante (instruction INC).

Cette architecture basée sur le déroulement d'une mémoire est déterministe en ce sens qu'elle suppose qu'il est possible a priori de savoir exactement ce qui va se passer à un instant donné sur les broches du circuit électronique à tester.

Un testeur de composants logiques est constitué de différentes parties :
- un système de programmation,
- un circuit de test par broche comprenant un ensemble de génération de stimuli, ou signaux de forçage, qui doivent être appliqués à la broche considérée, et un ensemble de comparaison des signaux de réponse du composant,
- un ou plusieurs ensembles d'interface, têtes de mesure, permettant d'adapter les stimuli aux contraintes du composant que l'on veut vérifier.

Le nombre des générateurs comparateurs de stimuli peut être de 32 jusqu'à 1024, dans le cas présent on se limite à 256 générateurs/comparateurs. Il peut y avoir par exemple deux têtes de mesure, chacune comportant 256 adaptateurs.

Afin d'optimiser le coût du test et la surface occupée par le testeur, il est possible de connecter des broches identiques de plusieurs têtes à un même circuit de test, c'est-à-dire à un même ensemble de génération/comparaison de stimuli. Généralement, des multiplexeurs (un par signal et par broche) placés en sortie de la partie génération/comparaison permettent d'aiguiller les signaux sur une tête ou sur l'autre. Ainsi, un composant est testé sur la tête n° 1 pendant qu'un autre composant est manipulé sur la tête n° 2 et inversement. Ceci permet d'augmenter la capacité du testeur en ajoutant une tête. Typiquement, si le temps de test est identique au temps de manipulation, l'adjonction d'une tête double la capacité du testeur.

S'agissant de composants identiques, il a été proposé des testeurs à deux têtes simultanées dans lesquels les mêmes stimuli sont générés en parallèle sur les deux têtes. De même, les signaux de réponse reçus sont comparés à une table simultanément par des circuits différents. Le testeur gère alors deux résultats : celui venant de la tête n° 1 et celui venant de la tête n° 2. Ainsi, en doublant simplement les circuits de génération et les circuits de comparaison à une table, on double réellement la capacité du testeur sachant que la table est la même pour la tête n° 1 que pour la tête n° 2 puisque les signaux générés et les composants à tester sont identiques.

Le test en parallèle permet donc de tester n composants simultanément de façon similaire au test d'un seul composant. Bien entendu, le test simultané peut se faire sur une même tête ou bien sur plusieurs têtes. La présente invention s'adresse à l'une et l'autre de ces deux alternatives.

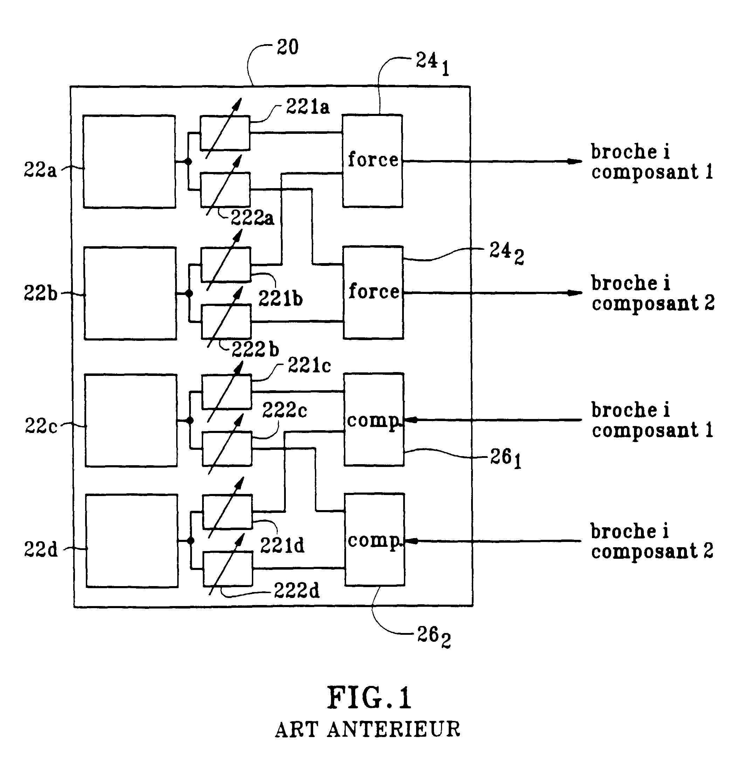

Pratiquement, le test en parallèle de composants électroniques est réalisé, de manière connue en soi, à l'aide de circuits de test tels que celui montré sur le schéma de la figure 1 dans le cas de deux composants, chacun de ces circuits permettant de tester des broches identiques de chaque composant.

L'ensemble de génération du circuit de test de la figure 1 comporte deux circuits de force destinés à fournir des stimuli, ou signaux de forçage, aux broches identiques des composants sous test, lesdits signaux de forçage étant formés à partir de deux générateurs de temps commandés par la mémoire de programmation, non représentée à la figure 1.

L'ensemble de comparaison comprend deux circuits de comparaison recevant des signaux de réponse des broches aux signaux de forçage, lesdits signaux de réponse étant comparés à des signaux de référence délivrés par deux autres générateurs de temps à partir d'une table fournie par la mémoire de programmation de test.

Dans la suite de ce mémoire, on appellera signal de test indifféremment un signal de forçage ou un signal de réponse.

On comprend qu'avec des circuits de test connus, du type de celui montré à la figure 1, les broches d'un composant sont mises en complète correspondance avec les mêmes broches de l'autre composant. Cette modalité particulière de test en parallèle, où les broches identiques sont forcées et comparées de manière synchrone, est bien adaptée au cas de composants dont le fonctionnement est parfaitement connu et identique d'un composant à l'autre.

Toutefois, on observera que la fréquence de répétition des signaux de test du circuit connu est limitée à celle des générateurs de temps.

Par ailleurs, il peut se produire que certaines broches des composants à tester ne doivent subir qu'une seule opération, forçage ou comparaison.

C'est précisément l'objet de la présente invention que de tirer profit de cette situation pour augmenter la fréquence des signaux de test, forçage ou comparaison respectivement, par la mise en oeuvre d'un procédé de test automatique en parallèle de composants électroniques, des broches identiques desdits composants échangeant des signaux de test avec au moins un même circuit de test, lequel comporte, d'une part, des générateurs de temps commandés par une mémoire de programmation de test, et, d'autre part, des circuits de force et des circuits de comparaison contrôlés par lesdits générateurs de temps, ledit procédé étant remarquable en ce que l'ensemble des générateurs de temps est affecté auxdits circuits de force, ou auxdits circuits de comparaison, de manière à obtenir des signaux de test synchrones sur lesdites broches identiques desdits composants électroniques.

Ainsi, comme on le verra en détail plus loin, en affectant toutes les ressources de marquage de temps aux circuits spécifiques de l'opération à effectuer sur les broches identiques concernées des composants électroniques ou test, on augmente la fréquence de répétition correspondante d'un facteur 2 voire même 4.

De même, selon l'invention, un équipement de test automatique en parallèle de composants électroniques, comprenant une pluralité de circuits de test associés respectivement à des broches identiques desdits composants, chaque circuit de test comportant, d'une part, des générateurs de temps commandés par une mémoire de programmation de test, et, d'autre part, des circuits de force et des circuits de comparaison contrôlés par lesdits générateurs de temps, est remarquable en ce que lesdits circuits de force, ou lesdits circuits de comparaison, d'au moins, un circuit de test sont connectés à l'ensemble des générateurs de temps de manière à ce que les signaux de test soient synchrones sur lesdites broches identiques desdits composants électroniques.

La description qui va suivre en regard des dessins annexés, donnés à titre d'exemples non limitatifs, fera bien comprendre en quoi consiste l'invention et comment elle peut être réalisée.

La figure 2 est un schéma d'un équipement de test en parallèle de composants électroniques.

La figure 3 est un schéma d'un circuit de test d'un équipement de test en parallèle conforme à l'invention.

La figure 4 est un schéma de deux circuits de test multiplexés d'un équipement de test en parallèle conforme à l'invention.

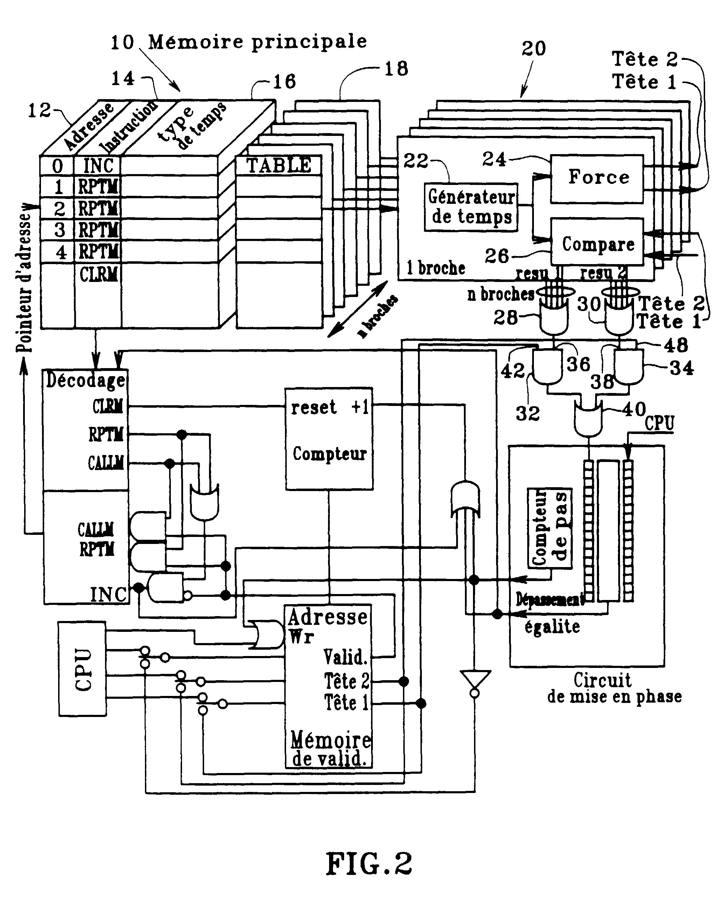

L'équipement de test en parallèle schématisé sur la figure 2 est décrit en détail dans la demande de brevet français n° 94 15559, seuls les éléments indispensables à la compréhension de la présente invention seront repris dans la suite de cet exposé.

La mémoire de programmation de test ou mémoire principale 10 contient les instructions nécessaires au déroulement de la séquence fonctionnelle de test.

Chaque adresse 12 de la mémoire principale 10 définit :
- une instruction 14 qui est commune à l'ensemble des broches sous test et qui gère le déroulement de la mémoire principale. On nomme CALLM et RPTM des instructions d'appel de la séquence de mise en phase. Lorsque ces instructions sont invoquées, le circuit de mise en phase est activé et gère ainsi le déroulement de la mémoire principale 10 ou des sous-programmes. L'instruction RPTM exécute la même ligne jusqu'à ce que la mise en phase soit trouvée. L'instruction CALLM exécute une série d'instructions jusqu'à ce que la mise en phase soit trouvée. L'instruction CALLM boucle ainsi la mémoire. L'instruction INC consiste simplement à passer à la ligne suivante.
- la définition du type de temps 16 à utiliser pendant l'exécution de cette adresse de la mémoire. Le type de temps est commun pour l'ensemble des broches du testeur et correspond à l'adresse d'une mémoire qui est par broche et dans laquelle est définie la valeur des temps correspondant à cette adresse. Cette architecture de définition des temps correspond à l'architecture dite "séquenceur par broche" qui fait l'objet du brevet US n°5,212,443.
- une table 18 qui correspond au contenu logique (0 ou 1 par exemple) des signaux à envoyer ou à comparer. Cette table est par broche. Le testeur reçoit du composant sous test des signaux de réponse qu'il compare aux données de la table 18.

La mémoire principale 10 de programmation de test permet de définir le signal à générer pour chaque broche. Ainsi, on définit une fonction élémentaire de génération ou de comparaison de signaux, identiques pour chaque broche qui, à partir des informations contenues dans la mémoire 10, génère les stimuli, ou signaux de forçage, et reçoit des signaux de réponse à comparer aux données de la table 18.

Ceci est réalisé à l'aide de circuits 20 de test identiques, chaque circuit étant affecté à une broche et comprenant un ensemble 22 de générateurs de temps contrôlant en parallèle, d'une part, un circuit 24 de force, ou générateur d'événements, envoyant des signaux de forçage aux composants situés, par exemple, sur deux têtes 1 et 2, et, d'autre part, un circuit 26 de comparaison recevant des signaux de réponse des tètes 1 et 2 et comparant ces signaux avec les données figurant dans la table 18.

L'ensemble 22 de générateurs de temps définit les instants auxquels il faut générer des fronts de signaux de forçage, les instants où il faut commencer la comparaison des signaux de réponse à la table 18 et les instants où il faut cesser de comparer. Lorsque le circuit 26 de comparaison effectue une comparaison, il génère un résultat, à savoir conforme ou non conforme à la table. Ce résultat est propre à chaque broche et à chaque composant sur lequel sont effectuées des comparaisons. Sur la figure 2, ce résultat est indiqué par "résu 1" pour la tête 1 et par "résu 2" pour la tête 2. En faisant un "ou" logique sur l'ensemble des broches à l'aide des portes OU 28 et 30, respectivement pour la tête 1 et la tête 2, il est possible de savoir si l'ensemble est conforme ou non.

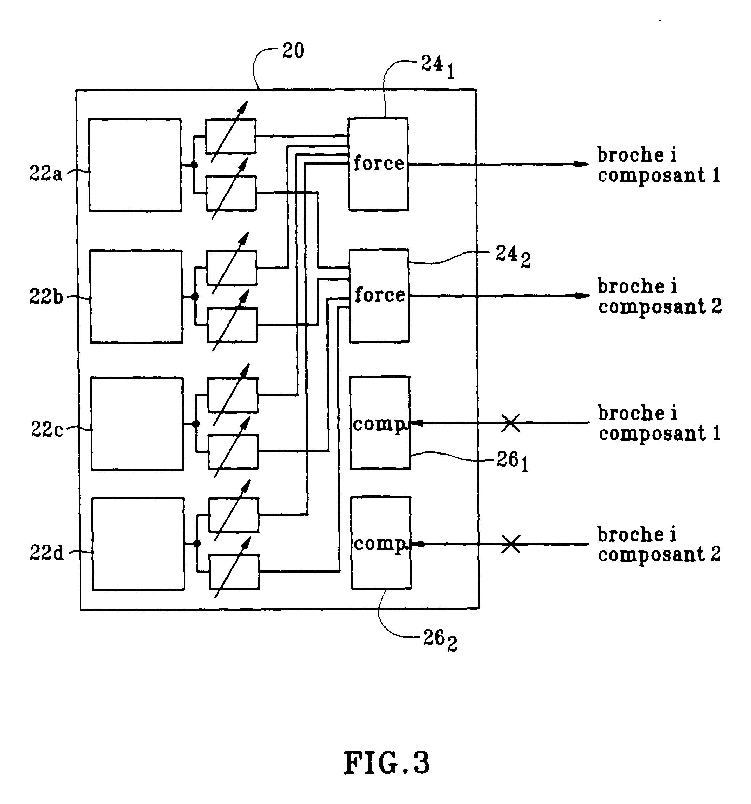

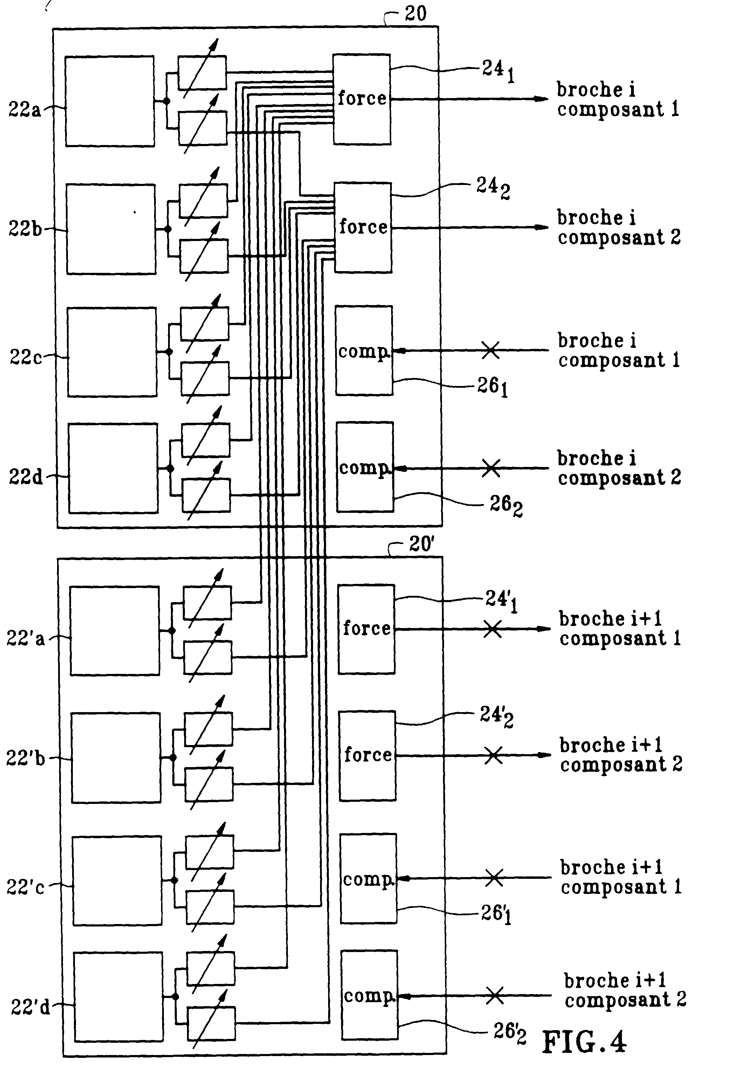

Comme l'indiquent de façon plus précise les figures 3 et 4, ainsi que la figure 1 de l'art antérieur, un circuit 20 de test en parallèle de deux composants 1 et 2 comporte un ensemble de générateurs de temps formé par quatre générateurs 22a, 22b, 22c, 22d destinés à contrôler des circuits 24₁, 24₂ de force et des circuits 26₁, 26₂ de comparaison. Chaque circuit 24₁, 24₂ de force est apte à délivrer un signal de forçage sur une broche i donnée des composants 1 et 2 à tester. En retour, le signal de réponse provenant de chaque broche i est susceptible d'être reçu par un circuit 26₁, 26₂ de comparaison respectif.

On notera également, en référence à la figure 1, la présence de circuits 22 la à 222d d'ajustement en temps des divers signaux de test sur une dynamique de l'ordre de 5 ns.

Sur la figure 1, les générateurs de temps 22a, ... 22d sont connectés aux circuits 24₁, 24₂ de force et aux circuits 26₁, 26₂ de comparaison de façon à obtenir des signaux de forçage, d'une part, et des signaux de réponse, d'autre part, synchrones entre eux, à une fréquence de répétition de 100 MHz par exemple.

La figure 3 illustre une situation où les broches i des composants électroniques 1 et 2 ne sont pas testées, les circuits 26₁, 26₂ de comparaison n'étant pas utilisés. Dans ce cas, il est prévu que l'ensemble des générateurs 22a, 22b, 22c, 22d sont affectés aux seuls circuits 24₁, 24₂ de force de manière que les signaux de forçage sur les broches identiques i des composants soient synchrones entre eux, mais cette fois avec une fréquence de répétition double de celle des signaux de test du circuit de la figure 1, à savoir par exemple 200 MHz au lieu de 100 MHz.

La figure 4 concerne un montage dans lequel un circuit 20 de test de broches identiques i d'une certaine parité est multiplexé à un circuit 20' de test de broches identiques i + 1 de parité opposée.

La situation représentée sur la figure 4 est la même que celle de la figure 1 en ce sens qu'un seul signal de test, de forçage par exemple, est appliqué aux seules broches identiques i d'une parité donnée des composants électroniques 1 et 2. Les circuits 24₁, 24₂ de force du circuit 20 de test sont alors connectés à l'ensemble des générateurs 22a, 22b, 22c, 22d ; 22'a, 22'b, 22'c, 22'd de temps de manière que les signaux de force soient synchrones sur lesdites broches identiques i de parité donnée des composants 1 et 2. La fréquence de répétition des signaux est encore doublée et atteint cette fois 400 MHz.

## Revendications

1. Procédé de test automatique en parallèle de composants électroniques, des broches identiques (i ; i + 1) desdits composants échangeant des signaux de test avec au moins un même circuit (20 ; 20') de test, lequel comporte, d'une part, des générateurs (22a, 22b, 22c, 22d ; 22'a, 22'b, 22'c, 22'd) de temps commandés par une mémoire (10) de programmation de test, et, d'autre part, des circuits (24₁, 24₂; 24'₁, 24'₂) de force et des circuits (26₁, 26₂ ; 26'₁, 26'₂) de comparaison contrôlés par lesdits générateurs de temps, caractérisé en ce que des générateurs de temps sont affectés soit auxdits circuits de force, soit auxdits circuits de comparaison, de manière à obtenir des signaux de test synchrones sur lesdites broches identiques (i) desdits composants électroniques.

2. Équipement de test automatique en parallèle de composants électroniques, comprenant une pluralité de circuits (20, 20') de test associés respectivement à des broches (i; i+1) identiques desdits composants, chaque circuit (20 ; 20') de test comportant, d'une part, des générateurs (22a, 22b, 22c, 22d, 22'a, 22'b, 22'c, 22'd) de temps commandés par une mémoire (10) de programmation de test, et, d'autre part, des circuits (24₁, 24₂ ; 24'₁, 24'₂) de force et des circuits (26₁, 26₂ ; 26'₁, 26'₂) de comparaison contrôlés par lesdits générateurs de temps, caractérisé en ce que lesdits circuits de force, ou lesdits circuits de comparaison, d'au moins un circuit de test sont connectés à l'ensemble des générateurs de temps de manière à ce que les signaux de test soient synchrones sur lesdites broches identiques (i) desdits composants électroniques.

3. Equipement selon la revendication 2, caractérisé en ce que les circuits (24₁, 24₂) de force, ou les circuits de comparaison, d'un même circuit (20) de test sont connectés à l'ensemble des générateurs (22a, 22b, 22c, 22d) de temps dudit circuit de test de manière que les signaux de test soient synchrones sur lesdites broches identiques (i) desdits composants électroniques.

4. Equipement selon la revendication 2, dans lequel un circuit (20) de test de broches identiques (i) d'une certaine parité est multiplexé à un circuit (20') de test de broches identiques (i+1) de parité opposée, caractérisé en ce que les circuits (24₁, 24₂) de force, ou les circuits et comparaison, d'un même circuit (20) de test sont connectés à l'ensemble des générateurs (22a, 22b, 22c, 22d ; 22a', 22'b, 22'c, 22'd) de temps des circuits (20 ; 20') de test de manière que les signaux de test soient synchrones sur lesdites broches identiques (i) de parité donnée desdits composants électroniques.

## Patentansprüche

1. Verfahren zum parallelen automatischen Prüfen von elektronischen Schaltungen, wobei identische Anschlußstifte (i; i + 1) der Schaltungen Testsignale mit mindestens einem Testschaltkreis (20; 20') austauschen, welcher einerseits Zeitgeneratoren (22a, 22b, 22c, 22d; 22'a, 22'b, 22'c, 22'd), die von einem Testprogrammierspeicher (10) gesteuert werden, und andererseits Beaufschlagungsstromkreise (24₁, 24₂; 24'₁, 24'₂) und Vergleichsschaltkreise (26₁, 26₂; 26'₁, 26'₂), die von den Zeitgeneratoren gesteuert werden, umfaßt, dadurch gekennzeichnet, daß die Zeitgeneratoren derart entweder den Beaufschlagungsstromkreisen oder den Vergleichsschaltkreisen zugeordnet sind, daß an den identischen Anschlußstiften (i) der elektronischen Schaltungen synchrone Testsignale erhalten werden.

2. Vorrichtung zum parallelen automatischen Prüfen von elektronischen Schaltungen, umfassend eine Vielzahl von Testschaltkreisen (20, 20'), die jeweils identischen Anschlußstiften (i; i + 1) der Schaltungen zugeordnet sind, wobei jeder Testschaltkreis (20; 20') einerseits von einem Testprogrammierspeicher (10) gesteuerte Zeitgeneratoren (22a, 22b, 22c, 22d; 22'a, 22'b, 22'c, 22'd) und andererseits von den Zeitgeneratoren gesteuerte Beaufschlagungsstromkreise (24₁, 24₂; 24'₁, 24'₂) und Vergleichsschaltkreise (26₁, 26₂; 26'₁, 26'₂) umfaßt, dadurch gekennzeichnet, daß die Beaufschlagungsstromkreise oder die Vergleichsschaltkreise mindestens eines Testschaltkreises mit der Gesamteit der Zeitgeneratoren so verbunden sind, daß die Testsignale an den identischen Anschlußstiften (i) der elektronischen Schaltungen synchron sind.

3. Vorrichtung nach Anspruch 2, dadurch gekennzeichnet, daß die Beaufschlagungsstromkreise (24₁, 24₂) oder die Vergleichsschaltkreise desselben Testschaltkreises (20) derart mit der Gesamtheit der Zeitgeneratoren (22a, 22b, 22c, 22d) des Testschaltkreises verbunden sind, daß die Testsignale an den identischen Anschlußstiften (i) der elektronischen Schaltungen synchron sind.

4. Vorrichtung nach Anspruch 2, bei welcher ein Testschaltkreis (20) für identische Anschlußstifte (i) einer bestimmten Parität an einen Testschaltkreis (20') für identische Anschlußstifte (i + 1) entgegengesetzter Parität gemultiplext wird, dadurch gekennzeichnet, daß die Beaufschlagungsstromkreise (24₁, 24₂) oder die Vergleichsschaltkreise desselben Testschaltkreises (20) mit der Gesamtheit der Zeitgeneratoren (22a, 22b, 22c, 22d; 22'a, 22'b, 22'c, 22'd) der Testschaltkreise (20; 20') derart verbunden sind, daß die Testsignale an den identischen Anschlußstiften (i) gegebener Parität der elektronischen Schaltungen synchron sind.

## Claims

1. A method of automatically testing electronic components in parallel, identical pins (i; i+1) of said components interchanging test signals with at least one common test circuit (20; 20') which includes, firstly, timing generators (22a, 22b, 22c, 22d; 22'a, 22'b, 22'c, 22'd) controlled by a test programming memory (10) and, secondly, forcing circuits (24₁, 24₂; 24'₁, 24'₂) and comparator circuits (26₁, 26₂; 26'₁, 26'₂) controlled by said timing generators, characterized in that the timing generators are assigned either to said forcing circuits or to said comparator circuits in such manner as to produce synchronous test signals at said identical pins (i) of said electronic components.

2. Equipment for automatically testing electronic components in parallel comprising a plurality of test circuits (20; 20') respectively associated with identical pins (i; i+1) of said components, each test circuit (20; 20') including, firstly, timing generators (22a, 22b, 22c, 22d; 22'a, 22'b, 22'c, 22'd) controlled by a test programming memory (10) and, secondly, forcing circuits (24₁, 24₂; 24'₁, 24'₂) and comparator circuits (26₁, 26₂; 26'₁, 26'₂) controlled by said timing generators, characterized in that said forcing circuits or said comparator circuits of at least one test circuit are connected to all the timing generators in such manner that the test signals are synchronous at said identical pins (i) of said electronic components.

3. Equipment according to claim 2 characterized in that the forcing circuits (24₁, 24₂) or the comparator circuits of the same test circuit (20) are connected to the timing generators (22a, 22b, 22c, 22d) of said test circuit in such manner that the test signals are synchronous at said identical pins (i) of said electronic components.

4. Equipment according to claim 2 wherein a circuit (20) for testing identical pins (i) with a certain parity is multiplexed with a circuit (20') for testing identical pins (i+1) with the opposite parity, characterized in that the forcing circuits (24₁, 24₂) or the comparator circuits of the same test circuit (20) are connected to the timing generators (22a, 22b, 22c, 22d; 22'a, 22'b, 22'c, 22'd) of the test circuits (20, 20') in such manner that the test signals are synchronous at said identical pins (i) of said electronic components.
